# EUROPEAN PATENT APPLICATION

(11) **EP 2 523 535 A1**
(43) Date of publication of application: **14.11.2012**
(21) Application number: 10842133.0
(22) Date of filing: 28.10.2010
(51) Int. Cl.: H05B 33/12, C09K 11/06, G02F 1/13357, H01L 51/50, H05B 33/14

(54) **RED FLUORESCENCE CONVERSION COMPOSITION AND RED FLUORESCENCE CONVERSION FILM**

(30) Priority: 08.01.2010 JP 2010002951
(71) Applicant: Harima Chemicals, INC., Kakogawa-shi, Hyogo 675-0019 (JP); Sharp Corporation, Osaka-shi, Osaka 545-8522 (JP)
(72) Inventor: KAWASHIMA, Shinichi, Kakogawa-shi Hyogo 675-0019 (JP); ISHIDA, Takeshi, Osaka-shi Osaka 545-8522 (JP); ISOBE, Shinichiro, Fukuoka-shi Fukuoka 811-1345 (JP); MATAKA, Shuntaro, Ohnojyo-shi Fukuoka 816-0904 (JP)
(74) Representative: HOFFMANN EITLE
(86) International application number: PCT/JP2010/069209
(87) International publication number: WO 2011/083618

(57) **Abstract**

A red fluorescence conversion composition includes a color conversion material (A) which absorbs light in a blue region and emits light having a fluorescence emission maximum in yellow-orange regions; a color conversion material (B) which absorbs light in the yellow-orange regions and emits light having a fluorescence emission maximum in the red region; and a matrix resin (C) for dispersing the color conversion materials (A) and (B). The color conversion material (A) is a condensed polycyclic compound made of a 5-membered ring compound having a conjugated system, and a 6-membered ring compound having a conjugated system with the 5-membered ring compound. The 5-membered ring compound contains at least one kind of atom selected from a hetero atom, a selenium atom, and a boron atom. A red fluorescence conversion film is made of the composition.

## Description

### TECHNICAL FIELD

The present invention relates to a red fluorescence conversion composition and a red fluorescence conversion film which are used for image display devices, such as liquid crystal display devices, organic EL display devices, and inorganic EL display devices.

### BACKGROUND ART

In the image display devices, such as the liquid crystal display devices, the organic EL display devices, and the inorganic EL display devices, energy loss becomes large with a conventional method of performing a full-color display with a color filter by using a cold cathode tube, a white organic EL, or the like, as a light source.

On the other hand, as a method of performing the full-color display, there is a method of using a color conversion material that absorbs light in a blue region obtained from a light source, such as a blue organic EL, a blue LED or the like, and then converts the light to green or red light, or using a color conversion film formed from the color conversion material (for example, patent document 1). It can be considered that this method allows for energy loss reduction and enhanced energy efficiency in comparison with an image display device using the conventional color filter, thereby permitting a brighter display with low power consumption.

However, there are limitations on color conversion materials exhibiting a wide Stokes shift for converting blue to red. The term "Stokes shift" means that an emission spectrum line and a spectrum band are shifted to a longer one than wavelengths of an absorption line and an absorption band, respectively. These color conversion materials do not exhibit high conversion efficiency.

A wide Stokes shift tends to widen a full width at half maximum of an emission spectrum (a spectrum width at half height of a peak). When used for the image display device, color purity is deteriorated, and it becomes necessary to cut excessive wavelength, thus lowering conversion efficiency.

Further, the conventional color conversion material has poor solubility with respect to a matrix resin and solvent, thus making it impossible to achieve sufficient absorbance, or high emission intensity cannot be achieved due to concentration quenching. For example, in patent document 2, a matrix resin and predetermined two kinds of fluorescence pigments are added to solvent and are dissolved therein. This is coated on a substrate and is fired, thereby obtaining a fluorescence member. The contents of the two kinds of fluorescence pigments in the obtained fluorescence member are respectively as low as 0.3% by weight (a total of 0.6% by weight), and the fluorescence member has large thickness of 10 µm.

### PRIOR ART DOCUMENTS

### PATENT DOCUMENTS

Patent document 1: Japanese Unexamined Patent Publication No. 3-152897
Patent document 2: Japanese Unexamined Patent Publication No. 2000-230172

### SUMMARY OF THE INVENTION

### PROBLEMS TO BE SOLVED BY THE INVENTION

An object of the present invention is to provide a red fluorescence conversion composition and a red fluorescence conversion film which are capable of efficiently converting the light in the blue region obtained from the light source to the light in the red region, and are also capable of obtaining sufficient absorption characteristics and color purity.

### MEANS FOR SOLVING THE PROBLEMS

Through their extensive research for solving the above problems, the present inventors have succeeded in finding a means for solution comprised of the following configuration, thereby completing the present invention.
(1) A red fluorescence conversion composition which absorbs light in a blue region obtained from a light source and emits light in a red region. The composition includes a color conversion material (A) which absorbs light in the blue region and emits light having a fluorescence emission maximum in yellow-orange regions; a color conversion material (B) which absorbs light in the yellow-orange regions and emits light having a fluorescence emission maximum in the red region; and a matrix resin (C) for dispersing the color conversion materials (A) and (B). The color conversion material (A) is a condensed polycyclic compound made of a 5-membered ring compound having a conjugated system, and a 6-membered ring compound having a conjugated system with the 5-membered ring compound. The 5-membered ring compound contains at least one kind of atom selected from a hetero atom, a selenium atom, and a boron atom.
(2) The red fluorescence conversion composition as set forth in item (1), in which the condensed polycyclic compound is an azole derivative or an imidazole derivative.
(3) The red fluorescence conversion composition as set forth in item (2), in which the azole derivative is a compound shown by the following general formula (1) or (2): 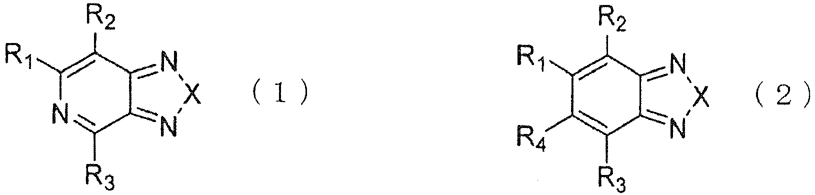 wherein R₁ to R₄ are respectively identical or different groups, and indicate a hydrogen atom, a halogen atom, a group: -COOR_{A} (wherein R_{A} indicates a linear or branched alkyl group having 1 to 10 carbon atoms), an aromatic hydrocarbon group, a hydrocarbon group, a heterocyclic group, or an aromatic group containing hetero atoms in the ring, each of which may have substituents; and X indicates a nitrogen atom, a sulfur atom, an oxygen atom, a selenium atom, or a boron atom, each of which may have substituents.
(4) The red fluorescence conversion composition as set forth in item (2), in which the imidazole derivative is a compound shown by the following general formula (3) or (4): 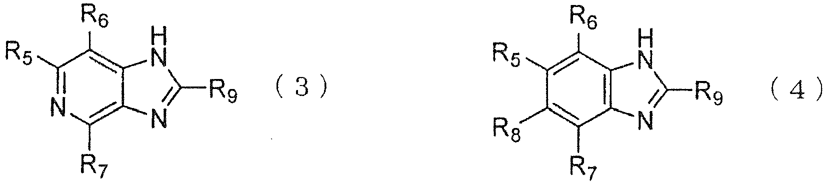 wherein R₅ to R₉ are respectively identical or different groups, and indicate a hydrogen atom, a halogen atom, a group: -COOR_{A} (wherein R_{A} indicates a linear or branched alkyl group having 1 to 10 carbon atoms), an aromatic hydrocarbon group, a hydrocarbon group, a heterocyclic group, or an aromatic group containing hetero atoms in the ring, each of which may have substituents.
(5) The red fluorescence conversion composition as set forth in any one of items (1) to (4), in which in the color conversion material (B), a full width at half maximum of an emission spectrum is 100 nm or less, and an x value and a y value shown by x- and y-coordinates on a CIE xy chromaticity diagram are 0.55 or more and 0.45 or less, respectively.
(6) The red fluorescence conversion composition as set forth in any one of items (1) to (5), in which a ratio by weight of the color conversion material (A) to the color conversion material (B) is 70:30 to 99.9:0.1.
(7) The red fluorescence conversion composition as set forth in any one of items (1) to (6), in which a total content of the color conversion materials (A) and (B) is to 30% by weight in terms of solid content with respect to the matrix resin (C).
(8) The red fluorescence conversion composition as set forth in any one of items (1) to (7), in which color conversion efficiency is 80% or more.
(9) A red fluorescence conversion film made of the red fluorescence conversion composition as set forth in any one of items (1) to (8).
(10) The red fluorescence conversion film as set forth in item (9), in which a film thickness is 0.5 to 9 µm.
(11) The red fluorescence conversion film as set forth in item (9) or (10), in which a mixture of the color conversion materials (A) and (B) is dispersed in the matrix resin (C).
(12) The red fluorescence conversion film as set forth in item (9) or (10), including a color conversion film (D) in which the color conversion material (A) is dispersed in the matrix resin (C); and a color conversion film (E) in which the color conversion material (B) is dispersed in the matrix resin (C). The color conversion films (D) and (E) are sequentially laminated from the light source side.
(13) A liquid crystal display device using the red fluorescence conversion film as set forth in any one of items (9) to (12).
(14) An organic EL display device using the red fluorescence conversion film as set forth in any one of items (9) to (12).
(15) An inorganic EL display device using the red fluorescence conversion film as set forth in any one of items (9) to (12).

### EFFECT OF THE INVENTION

According to the present invention, the light in the blue region obtained from the light source can be efficiently converted to the light in the red region, and sufficient absorption characteristics and color purity can be exhibited. When the red fluorescence conversion film of the present invention is employed on the image display device, such as the liquid crystal display device, the organic EL display device, the inorganic EL display device and the like, high brightness, thickness reduction, lower energy consumption or the like of the image display device are expectable.

### BRIEF DESCRIPTION OF THE DRAWINGS

Fig. 1 is an xy chromaticity diagram showing color purity of the color conversion material (B) according to the present invention;
Fig. 2 is a schematic illustrative drawing showing one embodiment of the liquid crystal display device using the red fluorescence conversion film of the present invention;
Fig. 3 is a schematic illustrative drawing showing another embodiment of the liquid crystal display device using the red fluorescence conversion film of the present invention; and
Fig. 4 is a schematic illustrative drawing showing one embodiment of the organic EL display device using the red fluorescence conversion film of the present invention.

### PREFERRED EMBODIMENTS FOR CARRYING OUT THE INVENTION

A red fluorescence conversion composition of the present invention absorbs light in a blue region obtained from a light source, such as a blue organic EL, a blue LED, or the like, and emits light in a red region. The composition contains color conversion materials (A) and (B), and a matrix resin (C).

The color conversion material (A) of the color conversion materials (A) and (B) absorbs the light in the blue region, and emits light having a fluorescence emission maximum in yellow-orange regions. The color conversion material (A) is a condensed polycyclic compound of a 5-membered ring compound and a 6-membered ring compound. The 5-membered ring compound contains at least one kind of atom selected from a hetero atom, a selenium atom, and a boron atom. Examples of the hetero atom include oxygen, sulfur, nitrogen, phosphorus or the like.

The 5-membered ring compound has a conjugated system. The 6-membered ring compound has a conjugated system with the 5-membered ring compound. The condensed polycyclic compound made of the 5-membered ring compound and the 6-membered ring compound exhibits high solubility with respect to the matrix resin (C) described later, and solvent, and also emits light by absorbing the light in the blue region, and by converting the light to light in the yellow-orange regions with high conversion efficiency.

Examples of the condensed polycyclic compound include azole derivatives and imidazole derivatives. Examples of the azole derivatives include compounds or the like shown by the general formula (1) or (2). Examples of the imidazole derivatives include compounds or the like shown by the general formula (3) or (4).

In the general formulas (1) to (4), R₁ to R₄ and R₅ to R₉ are respectively identical or different groups, and indicate a hydrogen atom, a halogen atom, a group: - COOR_{A} (wherein R_{A} indicates a linear or branched alkyl group having 1 to 10 carbon atoms), an aromatic hydrocarbon group, a hydrocarbon group, a heterocyclic group, or an aromatic group containing hetero atoms in the ring, each of which may have substituents.

Examples of the halogen atom include fluorine atom, chlorine atom, bromine atom, and iodine atom. Examples of the linear or branched alkyl group having 1 to 10 carbon atoms include methyl group, ethyl group, n-propyl group, isopropyl group, n-butyl group, isobutyl group, s-butyl group, t-butyl group, pentyl group, isopentyl group, neopentyl group, hexyl group or the like.

Examples of the aromatic hydrocarbon group include monovalent to trivalent aromatic hydrocarbon groups, namely, monovalent to trivalent groups or the like having a structure obtained by removing 1 to 3 hydrogen atoms bonded to the ring of the aromatic hydrocarbon. Examples of the aromatic hydrocarbon include benzene, naphthalene, biphenyl, anthracene, phenanthrene or the like. Specific examples in the case of the monovalent group are aryl groups such as phenyl group, tolyl group, xylyl group, naphthyl group, cumenyl group or the like. Specific examples in the case of the bivalent group are arylene groups such as phenylene, naphthylene, biphenylene, anthrylene, phenanthrylene or the like.

Examples of the hydrocarbon group include the linear or branched alkyl group or the like having 1 to 10 carbon atoms, which are the same as described above. Examples of the heterocyclic group include imidazolyl group, thiazolyl groul, pyridyl group, morpholino group, and tetrahydropyranyl group or the like. Examples of the aromatic group containing the hetero atom in the ring are benzothiophene group, indole group, benzofuran group or the like.

As the substituents that may be possessed by the aromatic hydrocarbon group, the hydrocarbon group, the heterocyclic group, and the aromatic group containing hetero atoms in the ring, there are for example a hydroxyl group; a cyano group; a sulfonyl group; the linear or branched alkyl group having 1 to 10 carbon atoms being the same as illustrated above; and a linear or branched alkoxy group having 1 to 10 carbon atoms, such as methoxy, ethoxy, n-propoxy, isopropoxy, n-butoxy, s-butoxy, t-butoxy, isobutoxy, n-pentyloxy, 2,2-dimethylpropoxy, cyclopentyloxy, n-hexyloxy, cyclohexyloxy, 2-metylpentyloxy, and 2-etylhexyloxy.

In the general formulas (1) and (2), X indicates a nitrogen atom, a sulfur atom, an oxygen atom, a selenium atom, or a boron atom, each of which may have substituents. Examples of the substituents include the same substituents as exemplified in the above-mentioned R₁ to R₄ and R₅ to R₉.

The azole derivatives shown by the general formulas (1) and (2), and the imidazole derivatives shown by the general formulas (3) and (4) are described in, for example, Japanese Unexamined Patent Publication No. 2005-208026. The azole derivatives (4,7-bis-(4-methoxyphenyl)-[1,2,5]oxadiazolo[3,4-c]pyridine-6-ethyl ester) shown by the following formula (5) described in synthesis example 1 of the publication is one of preferable condensed polycyclic compounds.

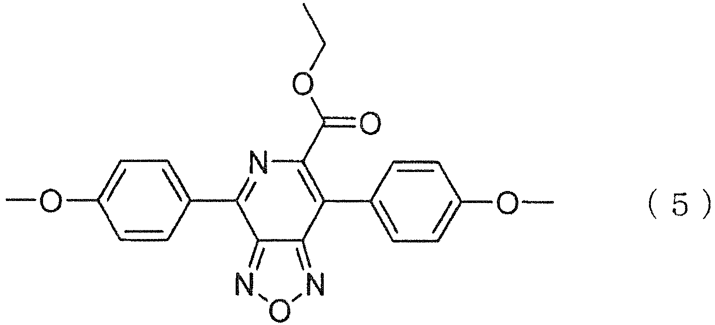

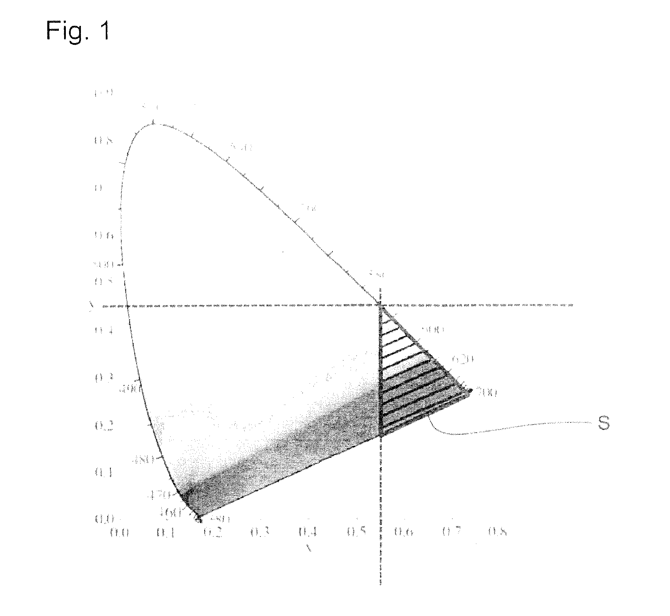

On the other hand, the color conversion material (B) absorbs the light in the yellow-orange regions emitted by the color conversion material (A), and emits light having a fluorescence emission maximum in the red region. The color conversion material (B) preferably has a narrow emission spectrum half width and high color purity. Specifically, the emission spectrum half width is preferably 100 nm or less, more preferably 80 nm or less. The color purity of the color conversion material (B) can be shown using x- and y-coordinates on a CIE xy chromaticity diagram, and it is preferable that an x value be 0.55 or more and a y value be 0.45 or less. High color purity red is obtainable in this range. When no chromaticity exists in this range, or the full width at half maximum of the emission spectrum is more than 100 nm, high color purity required by the image display device cannot be obtained due to mixed color. A region S (shaded area) shown in Fig. 1 is suitable for a range of the x value and the y value.

Examples of the color conversion material (B) include perylene type and rhodamine type red fluorescence pigments. Commercially available ones can be used as the color conversion material (B). For example, "Lumogen FRed 300" available from BASF Corporation is suitably used as the perylene type pigment. "Sulforhodamine 101" is suitably used as the rhodamine type pigment.

The color conversion material (A) is less susceptible to the influence of concentration quenching than the color conversion material (B). The color conversion material (A) has higher solubility with respect to the matrix resin (C) and the solvent than the color conversion material (B). Therefore, the composition preferably contains a larger amount of the color conversion material (A) than the color conversion material (B). Specifically, the ratio by weight of the color conversion material (A) to the color conversion material (B) is preferably 70:30 to 99.9:0.1. The following cases are not suitable. That is, when the ratio of the color conversion material (B) is larger than 30, it becomes difficult to obtain sufficient conversion efficiency by the influence of the concentration quenching, and it becomes less soluble in the matrix resin (C) and the solvent, thereby making it difficult to obtain a transparent color conversion film. When the ratio of the color conversion material (B) is smaller than 0.1, there is a probability that sufficient energy transfer from the color conversion material (A) to the color conversion material (B) does not occur, thus lowering conversion efficiency.

The matrix resin (C) is for dispersing the color conversion materials (A) and (B). No particular limitation is imposed on the matrix resin (C) as long as it can disperse the color conversion materials (A) and (B). Preferred examples thereof include thermosetting resin and thermoplastic resin.

Examples of the thermosetting resin include epoxy resin, urethane resin, melamine resin, polyester resin, phenol resin or the like. Examples of the thermoplastic resin include polyamide resin, polyethylene resin, polystyrene resin, acrylic resins such as poly(methyl methacrylate) resin or the like, and poly(vinyl chloride) resin or the like. One kind or two or more kinds of these may be mixingly used.

A total content of the color conversion materials (A) and (B) is preferably 1 to 30% by weight, more preferably 5 to 20 % by weight in terms of solid content with respect to the matrix resin (C). This achieves absorbance of 1 or more, and color conversion efficiency of 80% or more. On the contrary, the following cases are not suitable. That is, when the total content of the color conversion materials (A) and (B) is smaller than 1% by weight, it becomes difficult to obtain sufficient absorbance and color conversion efficiency. When the total content is larger than 30% by weight, it becomes difficult to be dissolved in the matrix resin (C), thus making it difficult to obtain a transparent color conversion film. When the absorbance is smaller than 1, the blue from the light source and the red obtained after conversion are mixed together, thus lowering color purity. When the color conversion efficiency is lower than 80%, sufficient brightness cannot be obtained. The absorbance is a value obtained by measurement using a visible-ultraviolet spectrophotometer. The color conversion efficiency is a value obtained by measurement at 450 nm excitation of a backlight wavelength by using an absolute quantum yield measurement device.

Next, a red fluorescence conversion film, which is one embodiment of the red fluorescence conversion composition of the present invention, is described below. The red fluorescence conversion film of the present invention is made of the red fluorescence conversion composition described above.

The red fluorescence conversion film has a film thickness of preferably 0.5 to 9 µm, more preferably 1 to 6 µm. As described above, the color conversion material (A) has the high solubility with respect to the matrix resin (C) and the solvent. Therefore, the high solubility of the color conversion material (A) with respect to the matrix resin (C) and the solvent contributes to a film thickness smaller than conventional ones. That is, even with decreasing the film thickness than the conventional ones, the color conversion materials (A) and (B) can be dispersed at a sufficient ratio in the matrix resin (C). Hence, when the red fluorescence conversion film is used for the image display device, such as the liquid crystal display apparatus, the organic EL display device and the inorganic EL display device, high brightness, thickness reduction, lower energy consumption, or the like are expectable. On the contrary, when the film thickness of the red fluorescence conversion film is smaller than 0.5 µm, it becomes difficult to obtain sufficient absorbance and conversion efficiency. Hence there is a probability that the color conversion film required by the image display device cannot be obtained, as described above.

As a structure of the red fluorescence conversion film, besides a structure that a mixture of the color conversion materials (A) and (B) is dispersed in the matrix resin (C), there is for example a structure or the like including a color conversion film (D) having the color conversion material (A) dispersed in the matrix resin (C), and a color conversion film (E) having the color conversion material (B) dispersed in the matrix resin (C), in which the color conversion films (D) and (E) are sequentially laminated from the light source side. When the film is configured to have a two-layer structure, the full film thickness is 0.5 to 9 µm, preferably 1 to 6 µm.

The red fluorescence conversion film can be formed by, for example, coating a resin solution in which the color conversion materials (A) and (B) and the matrix resin (C) are added to a predetermined solvent, onto a glass plate by using a spin coater or the like, followed by drying.

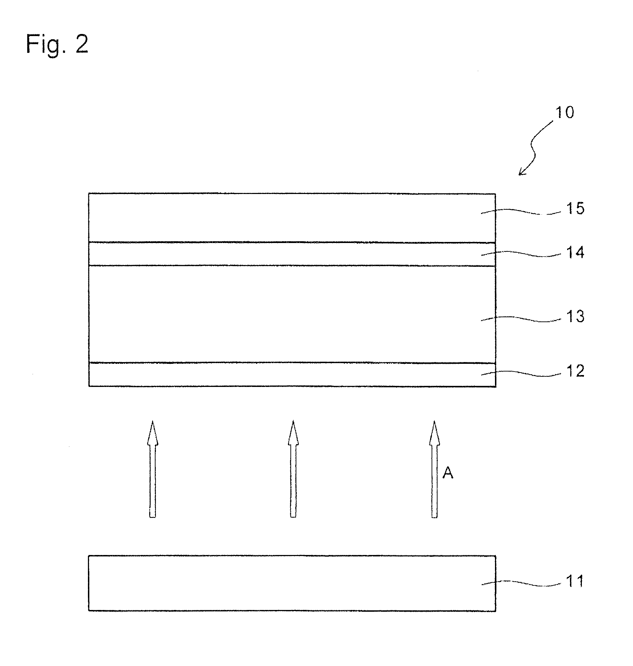

Next, embodiments where the red fluorescence conversion film of the present invention is used for the image display device are described in detail by illustrating the liquid crystal display device and the organic EL display device with reference to Figs. 2 to 4.

The liquid crystal display device 10 shown in Fig. 2 includes the light source 11 that emits blue light toward an observer in the direction of arrow A. The liquid crystal display device 10 includes a lower polarization layer 12, a liquid crystal layer 13, an upper polarization layer 14, and the red fluorescence conversion film 15 of the present invention, which are sequentially laminated from the light source 11.

The blue light emitted from the light source 11 in the direction of arrow A passes through the lower polarization layer 12, the liquid crystal layer 13 and the upper polarization layer 14 in that order. At this time, the intensity of the blue light passing through the upper polarization layer 14 can be changed optionally by changing a voltage applied to the liquid crystal layer 13. The blue light transmitted through the upper polarization layer 14 is absorbed by the red fluorescence conversion film 15, and the blue light is converted to red light by exciting the red conversion composition of the red fluorescence conversion film 15, thereby obtaining red pixels.

The liquid crystal display device 10 has green and blue pixels, besides the red pixels, and is configured to perform color development corresponding to each of these pixels. Display gradation is controlled by adjusting the voltage applied to the liquid crystal layer 13, and red, green and blue lights are emitted with the fluorescence conversion films corresponding to individual pixels, thereby allowing the liquid crystal display device 10 to perform color display.

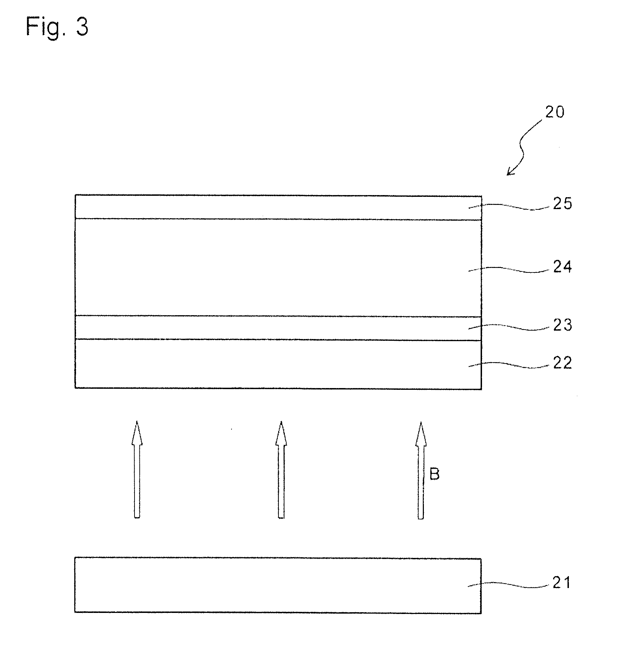

The liquid crystal display device 20 shown in Fig. 3 includes a light source 21 that emits blue light toward the observer in the direction of arrow B, and includes the red fluorescence conversion film 22 of the present invention, a lower planarization layer 23, a liquid crystal layer 24, and an upper planarization layer 25, which are sequentially laminated from the light source 21.

The blue light emitted from the light source 21 in the direction of arrow B is absorbed by the red fluorescence conversion film 22, and the blue light is converted to red light by exciting the red conversion composition of the red fluorescence conversion film 22. The red light passes through the lower polarization layer 23, the liquid crystal layer 24 and the upper polarization layer 25 in that order, thereby obtaining red pixels. At this time, the intensity of the red light passing through the upper polarization layer 25 can be changed optionally by changing the voltage applied to the liquid crystal layer 24.

Similarly to the liquid crystal display device 10, the liquid crystal display device 20 has green and blue pixels, besides the red pixels, and is configured to perform color development corresponding to each of these pixels. Display gradation is controlled by adjusting the voltage applied to the liquid crystal layer 24, and red, green and blue lights are emitted by the fluorescence conversion films corresponding to individual pixels, thereby allowing the liquid crystal display device 20 to perform color display.

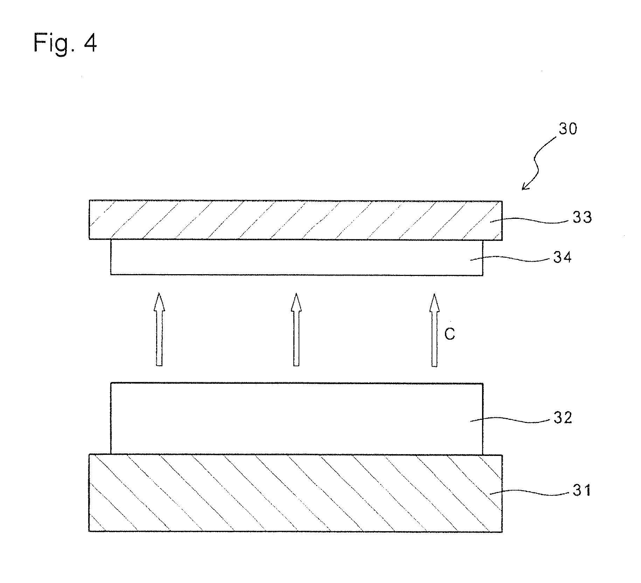

The organic EL display device 30 shown in Fig. 4 includes substrates 31 and 33 placed opposite with a predetermined distance interposed therebetween. An organic EL element 32 is formed on the surface of the substrate 31 opposed to the substrate 33, and the red fluorescence conversion film 34 of the present invention is formed on the surface of the substrate 33 opposed to the substrate 31.

The substrate 33 having the red fluorescence conversion film 34 formed thereon is positioned closer to the observer than the substrate 31 having the organic EL element 32 formed thereon. The organic EL element 32 emits blue light toward the red fluorescence conversion film 34 in the direction of arrow C. At this time, the intensity of the blue light can be changed optionally by controlling a current passing through the organic EL element 32, or by controlling light emission time.

The blue light emitted from the organic EL element 32 in the direction of arrow C is absorbed by the red fluorescence conversion film 34, and the blue light is converted to red light by exciting the red conversion composition of the red fluorescence conversion film 34, thereby obtaining red pixels.

The organic EL display device 30 has green and blue pixels, besides the red pixels, and is configured to perform color development corresponding to each of these pixels. Display gradation is controlled by the organic EL element 32, and red, green and blue lights are emitted by the fluorescence conversion films corresponding to individual pixels, thereby allowing the organic EL display device 30 to perform color display.

When the red fluorescence conversion films 15, 22, and 34 of the present invention are used for the liquid crystal display devices 10 and 20, and the organic EL display device 30, respectively, it is necessary to perform patterning of the individual pixels. The patterning can be performed by, for example, an inkjet method, a printing method or the like. The use of photocurable resin as the matrix resin (C) allows for patterning by photolithography.

Although the embodiments have been described taking the liquid crystal display device and the organic EL display device as the image display device, the present invention is not limited thereto. It is possible to use as the image display device using the red fluorescence conversion film, as long as the image display device has a light source emitting blue light, and carries out color display by performing color conversion of the blue light. A representative example is the inorganic EL display device.

The present invention is described in detail below with reference to Examples. However, it is noted that the present invention is not limited to the following Examples. The color conversion materials (A) and (B) and the matrix resin (C) used in the following Examples and Comparative Examples are as follows.

Color conversion material (A): The azole derivative shown by the formula (5) obtained in the following Reference Example was used.
Color conversion material (B1): The "Lumogen FRed 300" was used, which is the perylene type pigment, and is available from BASF Corporation.
Color conversion material (B2): Sulforhodamine 101 was used as the rhodamine type pigment.
Matrix resin (C): poly(methyl methacrylate) resin was used.

### [Reference Example]

According to the method described in the Synthesis Example 1 in the publication of Japanese Unexamined Patent Publication No. 2005-208026, the azole derivative (4,7-bis-(4-methoxyphenyl)-[1,2,5]oxadiazolo[3,4-c]pyridine-6-ethyl ester) shown by the following formula (5) was synthesized on the basis of the following formula:

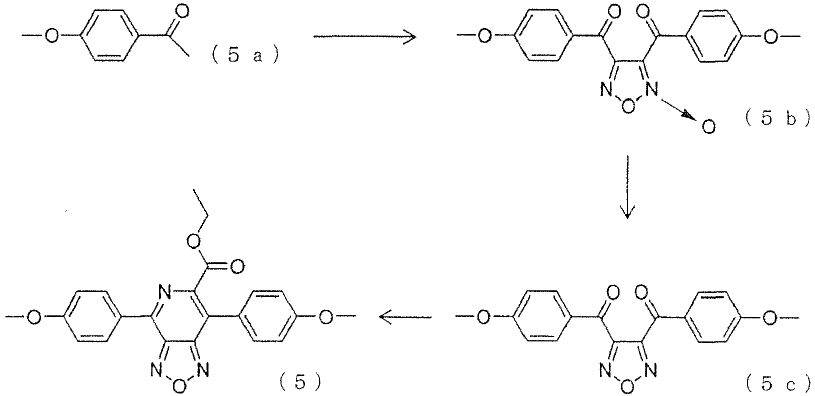

### (Synthesis of oxadiazole-N-oxide (5b))

Firstly, 37.5 g (0.25 mol) of 4-methoxyacetophenone (5a), 0.15 g of sodium nitrite, and 100 ml of acetic acid were added to a 500 ml three-necked flask, and they were dissolved therein.

On the other hand, a solution obtained by dissolving 100 ml of nitric acid in 100 ml of acetic acid in a water bath was dropped for two hours in the flask. After dropping, a mixture was stirred at room temperature (23°C) for two days. The obtained reaction mixture was poured slowly into 500 ml of water, thus causing precipitation. The obtained precipitation was filtered and dissolved in chloroform. A chloroform phase was washed with saturated aqueous sodium bicarbonate solution, and was washed twice with 10% aqueous sodium chloride solution. Then, this was dehydrated with magnesium sulfate, and the chloroform was distilled off under reduced pressure, thereby obtaining 34.5 g (a 78% yield) of oxadiazole-N-oxide (5b) in which one of two nitrogen atoms in a 5-membered ring compound forms coordinate bond to an oxygen atom. In the formula, "N→O" indicates the coordinate bond of the nitrogen atom to the oxygen atom.

### (Synthesis of oxadiazole-N-oxide (5c))

Next, 17.7 g (0.05 mol) of the oxadiazole-N-oxide (5b) obtained above was dissolved with 400 ml of acetonitrile in the 500 ml three-necked flask. To this solution, 12.0 g of zinc, 7 ml of acetic acid, and 20 ml of acetic anhydride were respectively added, followed by stirring while cooling in a water bath so that a reaction temperature did not exceed 30°C. The reaction was stopped after stirring for 12 hours. The reaction mixture was filtered to remove insoluble material. The acetonitrile was distilled off under reduced pressure, thereby obtaining residue. The residue was recrystallized from chloroform, thereby obtaining 10.2 g (a 60% yield) of oxadiazole-N-oxide (5c) in which no nitrogen atom in a 5-membered ring compound forms coordinate bond to an oxygen atom.

### (Synthesis of azole derivative (5))

Next, 15.6 g (0.046 mol) of the oxadiazole-N-oxide (5c) obtained above was dissolved with 300 ml of butanol in the 500 ml three-necked flask. To this solution, 32.0 g (0.23 mol) of glycine ethyl ester hydrochloride was added. This was heated under reflux for 24 hours. The butanol was distilled off under reduced pressure, thereby obtaining a residue. The residue was dissolved in 200 ml of chloroform, and was washed with 10% aqueous hydrochloric acid solution, saturated aqueous sodium bicarbonate solution, and 10% aqueous sodium chloride solution, respectively. Thereafter, this was dried with magnesium sulfate to distill off the solvent. The obtained residue was recrystallized from chloroform, thereby obtaining 13.0 g (a 70% yield) of 4,7-bis-(4-methoxyphenyl)-[1,2,5]oxadiazolo[3,4-c]pyridine-6-ethyl ester), which is the azole derivatives shown by the formula (5).

### [Examples 1 and 2, and Comparative Examples 1 to 3]

### <Manufacturing of Red Fluorescence Conversion Film>

The color conversion materials (A) and (B) were mixed in combination as shown in Table 1. Then, in Examples 1 and 2 among Examples 1 and 2 and Comparative Examples 1 to 3, the mixture of the color conversion materials (A) and (B), and the matrix (C) were mixed together so that a total content of the color conversion materials (A) and (B) was 13% by weight in terms of solid content with respect to the matrix resin (C). In Comparative Example 1, the color conversion material (A) and the matrix resin (C) were mixed together so that a content of the color conversion material (A) was 13% by weight in terms of solid content with respect to the matrix resin (C). In Comparative Examples 2 and 3, since color conversion materials (B1) and (B2) had poor solubility, the color conversion material (B1) or (B2) and the matrix resin (C) were mixed together in the following ratio. That is, in Comparative Example 2, the color conversion material (B1) and the matrix (C) were mixed together so that a content of the color conversion material (B1) was 1% by weight in terms of solid content with respect to the matrix resin (C). In Comparative Example 3, the color conversion material (B2) and the matrix (C) were mixed together so that a content of the color conversion material (B2) was 0.1% by weight in terms of solid content with respect to the matrix resin (C).

Then, each of the mixtures and propylene glycol monomethyl ether acetate as solvent were mix-dissolved in the ratio of 1:2 by weight, thereby obtaining individual resin solutions. Each of the obtained resin solutions was coated onto a 10-mm square glass plate with a thickness of 1 mm by using a spin coater. Then, these coated films were dried by heating at ambient temperature of 80°C, thereby obtaining red fluorescence conversion films respectively having a film thickness of approximately 5 µm.

### <Evaluation>

The obtained red fluorescence conversion films were evaluated in terms of absorbance, color conversion efficiency, full width at half maximum, and color coordinate. Their respective evaluation methods are described below, and the results thereof are presented together in Table 1.

### (Absorbance)

Absorbance at a wavelength 450 nm was measured with an ultraviolet-visible spectrophotometer ("V-650" available from JASCO Corporation).

### (Color conversion efficiency, Full width at half maximum, and Color coordinate)

Fluorescence emission upon irradiation of excitation slight of the wavelength 450 nm was measured with an absolute quantum yield measurement device ("C9920-12" available from Hamamatsu Photonics K.K.). Color conversion efficiency was calculated from a ratio of the number of photons absorbed by the red fluorescence conversion film and the number of emitted photons. At the same time, a full width at half maximum and a color coordinate of emission spectrum were measured.

**[Table 1]**

| | Combination of color conversion materials (A) and (B) | | Absorbance | Color conversion efficiency (%) | Full width at half maximum (nm) | Color coordinate | | |
|---|---|---|---|---|---|---|---|---|
| | Component | Ratio by weight | | | | x | y | Remark |
| Ex. 1 | Color conversion material (A) / Color conversion material (B1) | 99/5 | 2.1 | 85 | 75 | 0.648 | 0.336 | Red light |
| Ex. 2 | Color conversion material (A) / Color conversion material (B2) | 99/1 | 1.9 | 82 | 45 | 0.602 | 0.372 | Red light |
| Comp. Ex. 1 | Color conversion material (A) | — | 1.9 | 84 | 102 | 0.561 | 0.487 | Orange light |
| Comp. Ex. 2 | Color conversion material (B1) | — | 0.59 | 80 | 75 | 0.601 | 0.310 | Red light |
| Comp. Ex. 3 | Color conversion material (B2) | — | 0.11 | 22 | 45 | 0.608 | 0.388 | Red light |

| | | | | | | | | |
|---|---|---|---|---|---|---|---|---|
| 1)Color conversion material (A) : Azole derivative shown by the formula (5) Color conversion material (B1) : "Lumogen FRed 300" available from BASF Corporation as perylene type pigment Color conversion material (B2) : Sulforhodamine 101 | | | | | | | | |

As is apparent from Table 1, Examples 1 and 2 exhibited more satisfactory results of the evaluations in terms of absorbance, color conversion efficiency, half width and color coordinate than Comparative Examples 1 to 3.

## Claims

1. A red fluorescence conversion composition which absorbs light in a blue region obtained from a light source and emits light in a red region, comprising:
a color conversion material (A) which absorbs light in the blue region and emits light having a fluorescence emission maximum in yellow-orange regions;
a color conversion material (B) which absorbs light in the yellow-orange regions and emits light having a fluorescence emission maximum in the red region; and
a matrix resin (C) for dispersing the color conversion materials (A) and (B), wherein
the color conversion material (A) is a condensed polycyclic compound comprising a 5-membered ring compound having a conjugated system, and a 6-membered ring compound having a conjugated system with the 5-membered ring compound, and
the 5-membered ring compound contains at least one kind of atom selected from a hetero atom, a selenium atom, and a boron atom.

2. The red fluorescence conversion composition according to claim 1, wherein the condensed polycyclic compound is an azole derivative or an imidazole derivative.

3. The red fluorescence conversion composition according to claim 2, wherein the azole derivative is a compound shown by general formula (1) or (2): 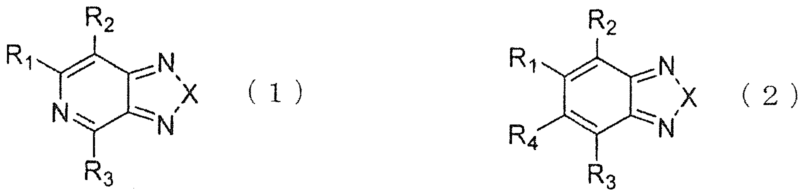 wherein R₁ to R₄ are respectively identical or different groups, and indicate a hydrogen atom, a halogen atom, a group: -COOR_{A} (wherein R_{A} indicates a linear or branched alkyl group having 1 to 10 carbon atoms), an aromatic hydrocarbon group, a hydrocarbon group, a heterocyclic group, or an aromatic group containing hetero atoms in the ring, each of which may have substituents; and X indicates a nitrogen atom, a sulfur atom, an oxygen atom, a selenium atom, or a boron atom, each of which may have substituents.

4. The red fluorescence conversion composition according to claim 2, wherein
the imidazole derivative is a compound shown by general formula (3) or (4): 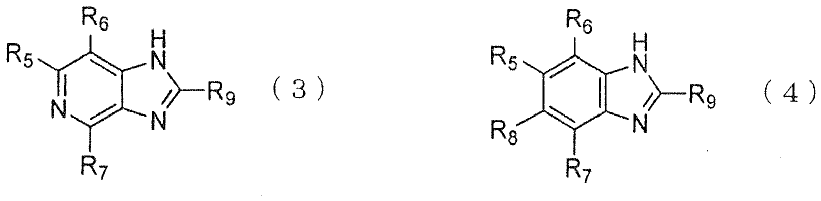 wherein R₅ to R₉ are respectively identical or different groups, and indicate a hydrogen atom, a halogen atom, a group: -COOR_{A} (wherein R_{A} indicates a linear or branched alkyl group having 1 to 10 carbon atoms), an aromatic hydrocarbon group, a hydrocarbon group, a heterocyclic group, or an aromatic group containing hetero atoms in the ring, each of which may have substituents.

5. The red fluorescence conversion composition according to any one of claims 1 to 4, wherein in the color conversion material (B), a full width at half maximum of an emission spectrum is 100 nm or less, and an x value and a y value shown by x- and y-coordinates on a CIE xy chromaticity diagram are 0.55 or more and 0.45 or less, respectively.

6. The red fluorescence conversion composition according to any one of claims 1 to 5, wherein a ratio by weight of the color conversion material (A) to the color conversion material (B) is 70:30 to 99.9:0.1.

7. The red fluorescence conversion composition according to any one of claims 1 to 6, wherein a total content of the color conversion materials (A) and (B) is 1 to 30% by weight in terms of solid content with respect to the matrix resin (C).

8. The red fluorescence conversion composition according to any one of claims 1 to 7, wherein color conversion efficiency is 80% or more.

9. A red fluorescence conversion film, comprising the red fluorescence conversion composition according to any one of claims 1 to 8.

10. The red fluorescence conversion film according to claim 9, wherein a film thickness is 0.5 to 9 µm.

11. The red fluorescence conversion film according to claim 9 or 10, wherein a mixture of the color conversion materials (A) and (B) is dispersed in the matrix resin (C).

12. The red fluorescence conversion film according to claim 9 or 10, comprising:
a color conversion film (D) in which the color conversion material (A) is dispersed in the matrix resin (C); and
a color conversion film (E) in which the color conversion material (B) is dispersed in the matrix resin (C), wherein
the color conversion films (D) and (E) are sequentially laminated from the light source side.

13. A liquid crystal display device using the red fluorescence conversion film according to any one of claims 9 to 12.

14. An organic EL display device using the red fluorescence conversion film according to any one of claims 9 to 12.

15. An inorganic EL display device using the red fluorescence conversion film according to any one of claims 9 to 12.
